(19) Europäisches Patentamt
European Patent Office
Office européen des brevets

(11) EP 2 531 892 B1

(12) **EUROPÄISCHE PATENTSCHRIFT**

(45) Veröffentlichungstag und Bekanntmachung des Hinweises auf die Patenterteilung:
**27.01.2016 Patentblatt 2016/04**

(21) Anmeldenummer: **11701279.9**

(22) Anmeldetag: **28.01.2011**

(51) Int Cl.:
***G03F 7/027*** *(2006.01)* ***G03F 7/035*** *(2006.01)*
***G03F 7/00*** *(2006.01)* ***G03H 1/00*** *(2006.01)*
***G11B 7/00*** *(2006.01)*

(86) Internationale Anmeldenummer:
**PCT/EP2011/051246**

(87) Internationale Veröffentlichungsnummer:
**WO 2011/095441 (11.08.2011 Gazette 2011/32)**

(54) **VERWENDUNG EINER PHOTOPOLYMER-FORMULIERUNG MIT TRIAZIN-BASIERTEN SCHREIBMONOMEREN**

USE OF A PHOTOPOLYMER FORMULATION WITH TRIAZINE-BASED WRITING MONOMERS

UTILISATION D'UNE COMPOSITION DE PHOTOPOLYMÈRE CONTENANT DES MONOMÈRES D'ÉCRITURE À BASE DE TRIAZINE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.02.2010 EP 10001006**

(43) Veröffentlichungstag der Anmeldung:
**12.12.2012 Patentblatt 2012/50**

(73) Patentinhaber: **Covestro Deutschland AG**
**51373 Leverkusen (DE)**

(72) Erfinder:
- **RÖLLE, Thomas**
  **51381 Leverkusen (DE)**
- **BRUDER, Friedrich-Karl**
  **47802 Krefeld (DE)**
- **FÄCKE, Thomas**
  **51375 Leverkusen (DE)**
- **WEISER, Marc-Stephan**
  **51379 Leverkusen (DE)**
- **HÖNEL, Dennis**
  **53909 Zülpich-Wichterich (DE)**

(74) Vertreter: **Levpat**
**c/o Covestro AG**
**Alfred-Nobel-Straße 10**
**40789 Monheim am Rhein (DE)**

(56) Entgegenhaltungen:
**EP-A1- 0 859 283**
**EP-A1- 1 229 389**
**WO-A1-2008/125200**
**JP-A- 56 152 467**
**JP-A- 2004 300 046**
**US-A- 5 496 504**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 531 892 B1

## Beschreibung

Die Erfindung betrifft die Verwendung einer Photopolymer-Formulierung umfassend Polyurethan Matrixpolymere, Schreibmonomere und Photoinitiatoren zur Herstellung holographischer Medien.

Photopolymer-Formulierungen der eingangs genannten Art sind im Stand der Technik bekannt. So ist beispielsweise in der WO 2008/125229 A1 eine Photopolymer-Formulierung beschrieben, die Polyurethan-basierte Matrixpolymere, ein Schreibmonomer auf Acrylatbasis sowie Photoinitiatoren enthält. Im ausgehärtetem Zustand sind in der Polyurethanmatrix das Schreibmonomer und die Photoinitiatoren räumlich isotrop verteilt eingebettet.

Aus der JP 2004 300046 A, der EP 1 229 389 A1 und der EP 0 859 283 A1 sind jeweils photopolymeriserbare Formulierungen bekannt, die Matrixpolymere, Photoinitiatoren und Triazin-Derivate enthalten. Allerdings werden in keinem der Dokumente Systeme beschrieben, bei denen Polyurethane als Matrixpolymere zum Einsatz kommen.

Für die Verwendungen von Photopolymer-Formulierungen spielt die durch die holographische Belichtung im Photopolymer erzeugte Brechungsindexmodulation $\Delta n$ die entscheidende Rolle. Bei der holographischen Belichtung wird das Interferenzfeld aus Signal- und Referenzlichtstrahl (im einfachsten Fall das zweier ebener Wellen) durch die lokale Photopolymerisation von z.B. hochbrechenden Acrylate an Orten hoher Intensität im Interferenzfeld in ein Brechungsindexgitter abgebildet. Das Brechungsindexgitter im Photopolymeren (das Hologramm) enthält alle Information des Signallichtstrahls. Durch Beleuchtung des Hologramms nur mit dem Referenzlichtstrahl kann dann das Signal wieder rekonstruiert werden. Die Stärke des so rekonstruierten Signals im Verhältnis zur Stärke des eingestrahlten Referenzlichts wird Beugungseffizienz, im folgenden DE wie Diffraction Efficiency, genannt.

Im einfachsten Fall eines Hologramms, das aus der Überlagerung zweier ebener Wellen entsteht ergibt sich die DE aus dem Quotienten der Intensität des bei der Rekonstruktion abgebeugten Lichtes und der Summe der Intensitäten aus eingestrahltem Referenzlicht und abgebeugtem Licht. Je höher die DE desto effizienter ist ein Hologramm in Bezug auf die Lichtmenge des Referenzlichtes die notwendig ist, um das Signal mit einer festen Helligkeit sichtbar zu machen.

Hochbrechende Acrylate sind in der Lage, Brechungsindexgitter mit hoher Amplitude zwischen Bereichen mit niedrigem Brechungsindex und Bereichen mit hohem Brechungsindex zu erzeugen und damit in Photopolymer-Formulierungen Hologramme mit hohem DE und hohem $\Delta n$ zu ermöglichen. Dabei ist zu beachten, dass DE vom Produkt aus $\Delta n$ und der Photopolymerschichtdicke d abhängt. Je größer das Produkt desto größer die mögliche DE (für Reflexionshologramme). Die Breite des Winkelbereiches bei dem das Hologramm z.B. bei monochromatischer Beleuchtung sichtbar (rekonstruiert) wird, hängt nur von der Schichtdicke d ab.

Bei Beleuchtung des Hologramms mit z.B. weißem Licht hängt die Breite des spektralen Bereiches, der zur Rekonstruktion des Hologramms beitragen kann, ebenfalls nur von der Schichtdicke d ab. Dabei gilt je kleiner d desto größer die jeweiligen Akzeptanzbreiten. Will man daher helle und leicht sichtbare Hologramme herstellen, ist ein hohes $\Delta n$ und eine geringe Dicke d anzustreben und zwar so, dass DE möglichst groß wird. Das heißt je höher $\Delta n$ wird, desto mehr Freiraum zur Gestaltung der Schichtdicke d für helle Hologramme erreicht man ohne Verlust an DE. Daher kommt der Optimierung von $\Delta n$ bei der Optimierung von Photopolymer-Formulierungen eine herausragenden Bedeutung zu (P. Hariharan, Optical Holography, 2nd Edition, Cambridge University Press, 1996).

Um ein möglichst hohes $\Delta n$ und DE bei Hologrammen realisieren zu können, sollten grundsätzlich die Matrixpolymere und die Schreibmonomere einer Photopolymer-Formulierung so gewählt werden, dass sie sich in ihren Brechungsindizes möglichst stark unterscheiden. In einer Ausführungsform bedeutet dies, dass Matrixpolymere mit einem möglichst niedrigen und Schreibmonomere mit einem möglichst hohen Brechungsindex verwendet werden. Allerdings gibt es bei dieser Vorgehensweise besondere Herausforderungen: So führt der hohe Brechungsindexunterschied zwischen Matrixpolymeren und Schreibmonomeren dazu, dass beide Komponenten nicht im beliebigem Maße mischbar sind, was auf die sich im Brechungsindexunterschied ausgedrückten strukturellen Unterschiede der Komponenten zurück zu führen ist. Dies bedeutet insbesondere, dass die verwendbare Menge an Schreibmonomer in der Photopolymer-Formulierung begrenzt ist, da es bei deren Überschreitung zur Entmischung der Komponenten kommt, was unbedingt vermieden werden muss. Ansonsten kann ein Medium aus einer entsprechenden Formulierung seine Funktionalität verlieren oder ein in ein derartiges Medium geschriebenes Hologramm sogar nachträglich beschädigt oder zerstört werden.

Es ist jedoch von Interesse, auch Photopolymer-Formulierungen mit höheren Gehalten an Schreibmonomeren zur Verfügung zu haben, da damit zum einen hellere Hologramme herstellbar sind und zum anderen auch mechanische Eigenschaften vorteilhaft eingestellt werden, um eine gute Integration des Hologramms in anderen Materialien zu ermöglichen. Darüber hinaus weisen die bekannten Photopolymer-Formulierungen häufig eine hohe Viskosität auf, was deren Verarbeitung erheblich behindert. So ist es beispielsweise schwierig die Formulierungen gleichmäßig auf ein zu beschichtendes Substrat zu applizieren. Große Probleme können auch entstehen, wenn die Formulierung gepumpt werden soll. In diesem Fall bleibt bisher nur als Lösung, die Temperatur der Formulierung zu erhöhen, um so die Viskosität zu reduzieren. Dies ist jedoch mit Hinblick auf die Gefahr einer ungewollt einsetzenden Polymerisierung der Formulierung kritisch.

Aufgabe der vorliegenden Erfindung war es daher, eine Photopolymer-Formulierung zur Herstellung von holographischen Medien bereit zu stellen, die im Vergleich zu bekannten Formulierungen eine geringere Viskosität aufweist, eine höhere Konzentration an Schreibmonomeren enthalten kann, ohne dass die oben beschriebenen negativen Effekte auftreten und mit der gleichzeitig helle Hologramme erhalten werden können.

Diese Aufgabe ist dadurch gelöst, dass die Schreibmonomere Verbindungen der Formel (I) enthalten

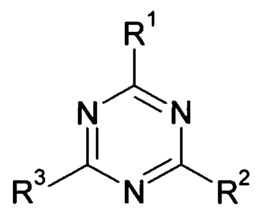

(I)

in der

$R^1$, $R^2$, $R^3$ jeweils unabhängig voneinander OH, Halogen oder ein organischer Rest sind, wobei wenigstens einer der Reste ein eine strahlungshärtende Gruppe aufweisender organischer Rest ist.

Hologramme, die beispielsweise in Filme aus der Photopolymer-Formulierung geschrieben werden, zeichnen sich durch ihre hohe Helligkeit aus. Außerdem ist es möglich, im Vergleich zu bekannten Photopolymer-Formulierungen, die Konzentration an Schreibmonomeren zu erhöhen, ohne dass eine Entmischung der Komponenten der Formulierung auftritt. Zuletzt zeichnen sich die Photopolymer-Formulierungen relativ zu bekannten Formulierungen durch eine niedrigere Viskosität aus, was die Transportierbarkeit und Verarbeitbarkeit deutlich verbessert.

Die Verbindungen der Formel (I) können beispielsweise durch Umsetzung der entsprechenden Amine oder Alkohole mit Cyanurchlorid erhalten werden. Bei dieser Reaktion handelt es sich um eine Aminierung bzw. Veretherung. Die Reaktion kann unter Zuhilfenahme bekannten Katalysatoren wie z.B. tertiärer Amine, Aniline oder stickstoffhaltiger Heterocyclen oder anorganischer Basen durchgeführt werden.

Die Herstellung derartiger Verbindungen ist beispielsweise in SU 2006990 (1976) und JP 58004027 beschrieben.

Gemäß einer bevorzugten Ausführungsform ist vorgesehen, dass der oder die organischen Reste über ein Sauerstoff- oder ein Stickstoffatom am Triazinring gebunden sind.

Bevorzugt ist weiterhin, wenn die strahlungshärtende Gruppe eine Acrylat- oder eine Methacrylat-Gruppe ist.

Besonders helle Hologramme können mit Photopolymer-Formulierungen erhalten werden, die Schreibmonomere enthalten bei denen $R^1$, $R^2$, $R^3$ unabhängig voneinander Halogen, substituierte oder unsubstituierte Phenol-, Naphtol-, Anilin-, Naphtalin-, 2-Hydroxyethyl(meth)acrylat-, Hydroxypropyl(meth)acrylat- und / oder 4-Hydroxybutyl(meth)acrylat-Reste sind, wobei wenigstens einer der Reste $R^1$, $R^2$, $R^3$ ein 2-Hydroxyethyl(meth)acrylat-, ein Hydroxypropyl(meth)acrylat- oder ein 4-Hydroxybutyl(meth)acrylat-Rest ist.

Weiter bevorzugt ist, wenn wenigstens zwei der Reste $R^1$, $R^2$, $R^3$ jeweils unabhängig voneinander ein 2-Hydroxyethyl(meth)acrylat-, ein Hydroxypropyl(meth)acrylat- und /oder ein 4-Hydroxybutyl(meth)acrylat-Rest sind. In diesem Fall weisen die Schreibmonomere der Formel (I) eine größere Doppelbindungsdichte auf. Daraus resultiert eine höhere Reaktivität, ein höherer Umsatz und eine stärkere chemische Vernetzung der Schreibmonomere in dem sich bildenden Poylacrylat. Die so erhaltenen vernetzten Schreibmonomere weisen ein höheres mittleres Molgewicht als ein auf einem monofunktionellen Schreibmonomer basierendes lineares Polymer und sind damit erheblich diffusionsstabiler und immobilisiert.

Eine größere Doppelbindungsdichte kann auch mit Hilfe von Mischungen mono- und höher Doppelbindungsfunktioneller Schreibmonomere beliebig eingestellt werden.

Die Matrixpolymere können insbesondere Polyurethane sein.

Vorzugsweise sind die Polyurethane durch Umsetzung einer Isocyanatkomponente a) mit einer Isocyanatreaktiven Komponente b) erhältlich.

Die Isocyanatkomponente a) umfasst bevorzugt Polyisocyanate. Als Polyisocyanate können alle dem Fachmann an sich gut bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendiisocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)methan und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat und/oder Triphenylmethan-4,4',4"-triisocyanat.

Ebenfalls möglich ist der Einsatz von Derivaten monomerer Di- oder Triisocyanate mit Urethan-, Harnstoff-, Carbodiimid-, Acylharnstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente a) um dioder oligomerisierte aliphatische und/oder cycloaliphatische Di- oder Triisocyanate.

Ganz besonders bevorzugt sind Isocyanurate, Uretdione und/oder Iminooxadiazindione basierend auf HDI, 1,8-Diisocyanato-4-(isocyanatomethyl)-octan oder deren Mischungen.

Ebenfalls können als Komponente a) NCO-funktionelle Prepolymere mit Urethan-, Allophanat-, Biuret- und/oder Amidgruppen eingesetzt werden. Prepolymere der Komponente a) werden in dem Fachmann an sich gut bekannter Art und Weise durch Umsetzung von monomeren, oligomeren oder Polyisocyanaten a1) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente a1) eingesetzt werden können, sind Butylendiisocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)-octan, Isocyanatomethyl-1,8-octandiisocyanat (TIN), 2,4- und/oder 2,6-Toluen-diisocyanat.

Als isocyanatreaktive Verbindungen a2) zum Aufbau der Prepolymere werden bevorzugt OH- funktionelle Verbindungen eingesetzt. Diese sind analog den OH-funktionellen Verbindungen wie sie nachfolgend für die Komponente b) beschrieben sind.

Ebenfalls möglich ist der Einsatz von Aminen zur Prepolymerherstellung. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere mit zahlenmittleren Molmassen bis 10000 g/Mol oder deren beliebige Gemische untereinander.

Zur Herstellung von biuretgruppenhaltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art.

Bevorzugte Prepolymere sind Urethane, Allophanate oder Biurete aus aliphatischen Isocyanat-funktionellen Verbindungen und oligomeren oder polymeren Isocyanat-reaktiven Verbindungen mit zahlenmittleren Molmassen von 200 bis 10000 g/Mol, besonders bevorzugt sind Urethane, Allophanate oder Biurete aus aliphatischen Isocyanat-funktionellen Verbindungen und oligomeren oder polymeren Polyolen oder Polyaminen mit zahlenmittleren Molmassen von 500 bis 8500 g/Mol und ganz besonders bevorzugt sind Allophanate aus HDI oder TMDI und difunktionellen Polyetherpolyolen mit zahlenmittleren Molmassen von 1000 bis 8200 g/Mol.

Bevorzugt weisen die vorstehend beschriebenen Prepolymere Restgehalte an freiem monomeren Isocyanat von weniger als 1 Gew.-%, besonders bevorzugt weniger als 0.5 Gew.-% und ganz besonders bevorzugt weniger als 0.2 Gew.-% auf.

Selbstverständlich kann die Isocyanatkomponente anteilsmäßig neben den beschriebenen Prepolymeren weitere Isocyanatkomponenten enthalten. Hierfür kommen aromatische, araliphatische, aliphatische und cycloaliphatische Di-, Tri- oder Polyisocyanate in Betracht. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat (TMDI), die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4"-triisocyanat oder deren Derivate mit Urethan-, Harnstoff-, Carbodiimid-, Acyl-harnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate,

die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die Isocyanatkomponente a) anteilsmäßig Isocyanate enthält, die teilweise mit isocyanat-reaktiven ethylenisch ungesättigten Verbindungen umgesetzt sind. Bevorzugt werden hierbei als isocyanat-reaktives ethylenisch ungesättigte Verbindungen $\alpha,\beta$-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt. Besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth)acrylat, Polyethylenoxid-mono(meth)acrylate, Polypropylenoxidmono(meth)-acrylate, Polyalkylenoxidmono(meth)acrylate, Poly($\varepsilon$-caprolacton)mono(meth)acrylate, wie z.B. Tone® M100 (Dow, USA), 2-Hydroxypropyl(meth)acrylat, 4-Hydroxybutyl(meth)-acrylat, 3-Hydroxy-2,2-dimethylpropyl(meth)acrylat, die hydroxyfunktionellen Mono-, Di- oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Der Anteil an Isocyanaten an der Isocyanatkomponente a), die teilweise mit isocyanat-reaktiven ethylenisch ungesättigten Verbindungen umgesetzt sind beträgt 0 bis 99 %, bevorzugt 0 bis 50 %, besonders bevorzugt 0 bis 25 % und ganz besonders bevorzugt 0 bis 15 %.

Es ist gegebenenfalls auch möglich, dass die vorgenannten Isocyanatkomponente a) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, $\varepsilon$-Caprolactam, N-tert.-Butyl-benzylamin, Cyclopentanoncarboxyethylester oder beliebige Gemische dieser Blockierungsmittel.

Als Komponente b) können an sich alle polyfunktionellen, isocyanatreaktiven Verbindungen eingesetzt werden, die im Mittel wenigstens 1.5 isocyanatreaktive Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität > 2 erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für geeignete Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, $\varepsilon$-Caprolacton und/oder Methyl-$\varepsilon$-caprolacton an hydroxyfunktionelle Verbindungen wie mehrwertige Alkohole einer OH-Funktionalität $\geq 2$ beispielsweise der vorstehend genannten Art erhalten werden können.

Solche Polyesterpolyole haben bevorzugt zahlenmittlere Molmassen von 400 bis 4000 g/Mol, besonders bevorzugt von 500 bis 2000 g/Mol. Ihre OH-Funktionalität beträgt bevorzugt 1.5 bis 3.5, besonders bevorzugt 1.8 bis 3.0.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität $\geq 2$, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders

bevorzugt von 500 bis 2000 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alykenoxidanteil nicht höher als 80 Gew.-% ist. Daneben sind Poly(trimethylenoxid)e gemäß Formel (III) sowie Mischungen der als bevorzugt genannten Polyole bevorzugt. Besonders bevorzugt sind Propylenoxid-homopolymere sowie statistische oder Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen umfasst hierbei alle jeweiligen linearen und verzweigten C3- und C4-Isomere.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.1.

Daneben sind als Bestandteile der Komponente b) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di-, tri- oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure (2,2-dimethyl-3-hydroxypropyl-ester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Die eingesetzten Photoinitiatoren sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

Die Photoinitiatoren können insbesondere einen anionischen, kationischen oder neutralen Farbstoff und einen Coinitiator umfassen.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethylbenzoyl-diphenylphosphinoxid, Bisacylophosphinoxide, Phenylglyoxylsäureester, Campherchinon, alpha-Aminoalkylphenon, alpha-,alpha-Dialkoxyacetophenon, 1-[4-(Phenylthio)phenyl]octan-1,2-dion-2-(O-benzoyloxim) und alpha-Hydroxyalkylphenon.

Auch die in EP-A 0223587 beschriebenen Photoinitiatorsysteme bestehend aus einer Mischung aus einem Ammoniumarylborat und einem oder mehreren Farbstoffen können als Photoinitiator eingesetzt werden. Als Ammoniumarylborat eignen sich beispielsweise Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenyl-butylborat, Tetrabutylammonium Tris-(3-fluorphenyl)-hexylborat, Tetramethylammonium Triphenylbenzylborat, Tetra(n-hexyl)ammonium (sec-Butyl)triphenylborat, 1-Methyl-3-octylimidazolium Dipentyldiphenylborat und Tetrabutylammonium Tris-(3-Chlor-4-methylphenyl)-hexylborat. Als Farbstoffe eignen sich beispielsweise Neu-Methylenblau, Thionin, Basic Yellow, Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29, Pyrillium I, Cyanin und Methylenblau, Azur A (Cunningham et al., RadTech'98 North America UV/EB Conference Proceedings, Chicago, Apr. 19-22, 1998).

Die für die anionische Polymerisation verwendeten Photoinitiatoren sind in der Regel (Typ I)-Systeme und leiten sich von Übergangsmetall-Komplexen der ersten Reihe ab. Hier sind Chrom-Salze, wie z.B. trans-$Cr(NH_3)_2(NCS)_4^-$ (Kutal et al, Macromolecules 1991, 24, 6872) oder Ferrocenyl-Verbindungen (Yamaguchi et al. Macromolecules 2000, 33, 1152). Eine weitere Möglichkeit der anionischen Polymerisation besteht in der Verwendung von Farbstoffen, wie Kristallviolett Leukonitril oder Malchit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut,

so dass die resultierenden Polymere durchgefärbt sind.

Die für die kationische Polymerisation verwendeten Photoinitiatoren bestehen im wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch in Abwesenheit eines Wasserstoff-Donors ein Kation erzeugten, dass die Polymerisation initiiert. Die Effizienz des Gesamtsystems wird durch die Natur des verwendeten Gegenions zur Diazonium-Verbindung bestimmt. Bevorzugt sind hier die wenig reaktiven aber recht teuren $SbF_6^-$, $AsF_6^-$ oder $PF_6^-$. Für den Einsatz in Beschichtung dünner Filme sind diese Verbindungen i.d.R wenig geeignet, da die den nach der Belichtung freigesetzten Stickstoff die Oberflächegüte herabgesetzt wird (pinholes) (Li et al., Polymeric Materials Science and Engineering, 2001, 84, 139).

Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalanion, welches sich durch H-Abstraktion stabilisiert und ein Proton freisetzt und dann die kationische Polymerisation startet (Dektar et al. J. Org. Chem. 1990, 55, 639; J. Org. Chem., 1991, 56. 1838). Dieser Mechanimus ermöglicht den Einsatz von Iodonium-Salzen ebenfalls für die radikalische Photopolymerisation. Hierbei kommt erneut der Wahl des Gegenions eine große Bedeutung zu, bevorzugt werden ebenfalls $SbF_6^-$, $AsF_6^-$ oder $PF_6^-$. Ansonsten ist in dieser Strukturklasse die Wahl der Substitution des Aromaten recht frei und im wesentlichen durch die Verfügbarkeit geeigneter Startbausteine für die Synthese bestimmt.

Bei den Sulfonium-Salzen handelt es sich um Verbindungen, die in nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6^-$ Salzen erzielt.

Da die Eigenabsorption von Iodonium- und Sulfonium-Salze bei <300nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivate (Hua et al, Macromolecules 2001, 34, 2488-2494).

Es kann vorteilhaft sein, Gemische dieser Verbindungen einzusetzen. Je nach zur Härtung verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Bevorzugte Photoinitiatoren sind Mischungen aus Tetrabutylammonium Tetrahexylborat, Tetrabutylammonium Triphenylhexylborat, Tetrabutylammonium Tris-(3-fluorphenyl)-hexylborat ([191726-69-9], CGI 7460, Produkt der Ciba Inc, Basel) und Tetrabutylammonium Tris-(3-Chlor-4-methylphenyl)-hexylborat ([1147315-11-4], CGI 909, Produkt der Ciba Inc, Basel) mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Gemäß einer weiteren bevorzugten Ausführungsform ist vorgesehen, dass die Photopolymer-Formulierung zusätzlich Urethane als Weichmacher enthält, wobei die Urethane insbesondere mit wenigstens einem Fluoratom substituiert sein können.

Bevorzugt können die Urethane die allgemeine Formel (II)

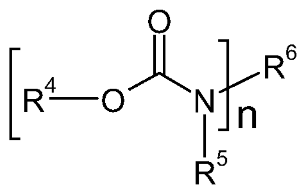

(II)

haben, in der n≥1 und n≤8 ist und $R^4$, $R^5$, $R^6$ unabhängig voneinander Wasserstoff, lineare, verzweigte, cyclische oder heterocyclische unsubstituierte oder gegebenenfalls auch mit Heteroatomen substituierte organische Reste sind, wobei bevorzugt mindestens einer der Reste $R^4$, $R^5$, $R^6$ mit wenigstens einem Fluoratom substituiert ist und besonders bevorzugt $R^4$ ein organischer Rest mit mindestens einem Fluoratom ist. Besonders bevorzugt ist $R^6$ ein linearer, verzweigter, cyclischer oder heterocyclischer unsubstituierter oder gegebenenfalls auch mit Heteroatomen wie beispielsweise Fluor substituierter organischer Rest.

Bei einer weiteren bevorzugten Ausführungsform ist vorgesehen, dass die Schreibmonomere zusätzlich ein weiters mono- oder multifunktionales Schreibmonomer umfassen, wobei es sich insbesondere um ein mono- oder multifunktionelles Acrylat handeln kann.

Das Acrylat kann insbesondere die allgemeine Formel (III)

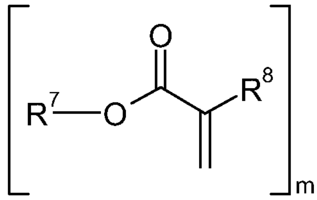

(III)

aufweisen, in der m≥1 und m≤4 ist und $R^7$, $R^8$ unabhängig voneinander Wasserstoff, lineare, verzweigte, cyclische oder heterocyclische unsubstituierte oder gegebenenfalls auch mit Heteroatomen substituierte organische Reste sind. Besonders bevorzugt ist $R^8$ Wasserstoff oder Methyl und/oder $R^7$ ein linearer, verzweigter, cyclischer oder heterocyclischer unsubstituierter oder gegebenenfalls auch mit Heteroatomen substituierter organischer Rest.

Ebenso ist es möglich, dass weitere ungesättigte Verbindungen wie α,β-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol, Olefinine, wie z.B. 1-Octen und/oder 1-Decen, Vinylestern, (Meth)acrylnitril, (Meth)acrylamid, Methacrylsäure, Acrylsäure zugesetzt werden. Bevorzugt sind Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p-Chlorphenylacrylat, p-Chlorphenylmethacrylat, p-Bromphenylacrylat, p-Bromphenyl-methacrylat, 2,4,6-Trichlorphenylacrylat, 2,4,6-Trichlorphenylmethacrylat, 2,4,6-Tribromphenyl-acrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate, um nur eine Auswahl verwendbarer Acrylate und Methacrylate zu nennen.

Selbstverständlich können auch Urethanacrylate verwendet werden. Unter Urethanacrylaten versteht man Verbindungen mit mindestens einer Acrylsäureestergruppe, die zusätzlich über mindestens eine Urethanbindung verfügen. Es ist bekannt, dass solche Verbindungen durch Umsetzung eines Hydroxy-funktionellen Acrylsäureesters mit einer Isocyanat-funktionellen Verbindung erhalten werden können.

Beispiele hierfür verwendbarer Isocyanat-funktionelle Verbindungen sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)oktan, 2,2,4-und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, m-Methylthiophenylisocyanat, Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise Verbindungen in Betracht wie 2-Hydroxyethyl(meth)acrylat, Polyethylenoxid-mono(meth)acrylate, Polypropylenoxidmono(meth)acrylate, Polyalkylenoxidmono(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono(meth)acrylate. Darüber hinaus sind als isocyanat-reaktive oligomere oder polymere ungesättigte Acrylat-und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)-acrylaten oder Mischungen hydroxylgruppenhaltiger ungesättigter Polyester mit Polyester(meth)acrylaten.

Bevorzugt sind insbesondere Urethanacrylate erhältlich aus der Umsetzung von Tris(p-isocyanatophenyl)thiophosphat und m-Methylthiophenylisocyanat mit alkoholfunktionellen Acrylaten wie 2-Hydroxyethyl(meth)acrylat, Hydroxypropyl(meth)acrylat und 4-Hydroxybutyl(meth)acrylat.

Ein weiterer Gegenstand der Erfindung ist die Verwendung einer erfindungsgemäßen Photopolymer-Formulierung zur Herstellung holographischer Medien, die durch entsprechende Belichtungsprozesse für optische Anwendungen im gesamten sichtbaren und nahen UV-Bereich (300-800 nm) zu Hologrammen verarbeitet werden können. Visuelle Hologramme umfassen alle Hologramme, die nach dem Fachmann bekannten Verfahren aufgezeichnet werden können. Darunter fallen unter anderem In-Line (Gabor) Hologramme, Off-Axis Hologramme, Full-Aperture Transfer Hologramme, Weißlicht-Transmissionshologramme ("Regenbogenhologramme), Denisyukhologramme, Off-Axis Reflektionshologramme, Edge-Lit Hologramme sowie holographische Stereogramme. Bevorzugt sind Reflexionshologramme, Denisyukhologramme, Transmissionshologramme.

Mögliche optische Funktionen der Hologramme, die mit den erfindungsgemäßen Photopolymer-Formulierungen hergestellt werden können entsprechen den optische Funktionen von Lichtelementen wie Linsen, Spiegel, Umlenkspiegel, Filter, Streuscheiben, Beugungselemente, Lichtleiter, Lichtlenker (waveguides), Projektionsscheiben und/oder Masken. Häufig zeigen diese optischen Elemente eine Frequenzselektivität, je nachdem wie die Hologramme belichtet wurden und welche Dimensionen das Hologramm hat.

Zudem können mittels der erfindungsgemäßen Photopolymer-Formulierungen auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellen Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

Die Photopolymere-Formulierungen können insbesondere als holografisches Medium in Form eines Films verwendet werden. Dabei wird als Träger eine Lage eines für Licht im sichtbaren Spektralbereich (Transmission größer als 85% im Wellenlängenbereich von 400 bis 780 nm) transparenten Materials oder Materialverbunds ein- oder beidseitig beschichtet sowie ggf. eine Abdeckschicht auf der oder den Photopolymerlagen appliziert.

Bevorzugte Materialien oder Materialverbünde des Trägers basieren auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Besonders bevorzugt basieren sie auf PC, PET und CTA. Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders bevorzugt sind PC/PET, PET/PC/PET und PC/TPU (TPU = Thermoplastisches Polyurethan).

Alternativ zu den vorgenannten Kunststoffträgern können auch planare Glasplatten eingesetzt werden, die insbesondere für großflächige abbildungsgenaue Belichtungen Verwendung finden, z.B. für holographische Lithographie (Ng, Willie W.; Hong, Chi-Shain; Yariv, Amnon. Holographic interference lithography for integrated optics. IEEE Transactions on Electron Devices (1978), ED-25(10), 1193-1200, ISSN:0018-9383).

Die Materialien oder Materialverbünde des Trägers können einseitig oder beidseitig antihaftend, antistatisch, hydrophobiert oder hydrophiliert ausgerüstet sein. Die genannten Modifikationen dienen an der Photopolymerschicht zugewandten Seite dem Zweck, dass die Photopolymerlage von dem Träger zerstörungsfrei abgelöst werden kann. Eine Modifikation der der Photopolymerlage abgewandten Seite des Trägers dient dazu, dass die erfindungsgemäßen Medien speziellen mechanischen Anforderungen genügen, die z.B. bei der Verarbeitung in Rollenlaminatoren, insbesondere bei Rolle-zu-Rolle-Verfahren, gefordert sind.

## Beispiele

Die Erfindung wird im Folgenden anhand von Beispielen näher erläutert. Sofern nicht abweichend vermerkt

verstehen sich dabei alle Prozentangaben als Gewichtsprozente.

**Methoden:**

Die Festgehalte wurden bestimmt, indem entweder unter Berücksichtigung der Bedienungsanleitung der IR-Waage ca. 1 g Substanz auf eine spezielle Einweg-Aluschale aufgetragen und bei 140°C solange erhitzt werden, bis 30 Sekunden Gewichtskonstanz besteht oder ca. 1 g Substanz auf eine spezielle Einweg-Aluschale aufgetragen wird (geeignet für Systeme mit einem maximalen Lösemittelgehalt von 10 Gew.-%) und bei 125°C für 60 Minuten im Trockenschrank erhitzt wird. Dabei wird die zu bestimmende Substanz mithilfe einer geeignet gebogenen Büroklammer so verteilt, dass eine gleichmäßige Trocknung des Film gewährleistet ist. Die Büroklammer verbleibt zur Messung in der Probe und muss schon bei der Einwaage berücksichtigt werden.

Die angegebenen NCO-Werte (Isocyanat-Gehalte) wurden gemäß DIN EN ISO 11909 bestimmt.

Die Bestimmung des Gehaltes an 2-Hydroxyethylacrylat (HEA) wird in Anlehnung an DIN/ISO 10283 (2007) durchgeführt. 1.41 g Anthracen (Kalibriersubstanz) als interne Standardsubstanz werden in einem 1 Liter Messkolben eingewogen und mit Ethylacetat aufgefüllt. Ca. 1 g Probe wird eingewogen und mit 10 mL der wie oben beschrieben hergestellten Lösung des internen Standards und 10 mL Ethylacetat versetzt, davon werden 2.0 μL gaschromatographisch aufgetrennt und der Gehalt an HEA flächenkorrigiert in Gew.-% berechnet.

Die Viskosität wurde auf einem CP25-1 der Fa. Anton Paar (Ostfildern, Deutschland) mittels Kegel-Platte-Aufbau gemäß ISO 3214 bestimmt und in mPa*s angegeben.

Messung des Brechungsindex bei einer Wellenlänge von 405 nm (Methode A): Der Brechungsindex n in Abhängigkeit von der Wellenlänge der Proben wurden aus den Transmissions- und Reflexionsspektren erhalten. Dazu wurden ca. 100 - 300 nm dicke Filme der Proben auf Quarzglasträger aus verdünnter Lösung in Butylacetat aufgeschleudert. Das Transmissions- und Reflexionsspektrum dieses Schichtpaketes wurde mit einem Spektrometer der Firma STEAG ETA-Optik, CD-Measurement System ETA-RT gemessen und danach die Schichtdicke und der spektrale Verlauf von n an die gemessenen Transmissions- und Reflexionsspektren angepasst. Dies geschieht mit der internen Software des Spektrometers und erfordert zusätzlich die n Daten des Quarzglassubstrates, die in einer Blindmessung vorab bestimmt wurden.

Messung des Brechungsindex bei einer Wellenlänge von 589 nm (Methode B): Eine Probe der Beispiel-Verbindung wurde ein Abbe-Refraktometer gegeben und nD gemessen.

Mit einem holographischen Versuchsaufbau wie in Figur 1 dargestellt, wurden die Beugungseffizienz (DE) der Medien gemessen.

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die $\lambda/2$ Plättchen wurden die Leistung des Referenzstrahls auf 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel ($\alpha_0$) des Referenzstrahls beträgt -21.8°, der Einfallswinkel ($\beta_0$) des Signalstrahls beträgt 41.8°. Die Winkel werden ausgehend von der Probennormale zur Strahlrichtung gemessen. Gemäß Figur 1 hat daher $\alpha_0$ ein negatives Vorzeichen und $\beta_0$ ein positives Vorzeichen. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand Λ, auch Gitterperiode genannt, im Medium beträgt ~ 225 nm (der Brechungsindex des Mediums zu ~1.504 angenommen).

Figur 1 zeigt die Geometrie eines Holographic Media Testers (HMT) bei $\lambda$ = 633 nm (He-Ne Laser): M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, I = Irisblende, $\alpha_0$ = - 21.8°, $\beta_0$ = 41.8° sind die Einfallswinkel der kohärenten Strahlen außerhalb der Probe (des Mediums) gemessen. RD = Referenzrichtung des Drehtisches.

Mit einem holographischen Versuchsaufbau wie in Figur 1 dargestellt wurden die Beugungseffizienz (DE) der Medien gemessen.

Es wurden auf folgende Weise Hologramme in das Medium geschrieben:

- Beide Shutter (S) sind für die Belichtungszeit t geöffnet.
- Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen

Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega_{min}$ bis $\Omega_{max}$ mit einer Winkelschrittweite von 0.05°. $\Omega$ wird von der Probennormale zur Referenzrichtung des Drehtisches gemessen. Die Referenzrichtung des Drehtisches ergibt sich dann wenn beim Schreiben des Hologramms der Einfallswinkel des Referenz- und des Signalstrahls betragsmäßig gleich sind also $\alpha_0$ = -31.8° und $\beta_0$ = 31.8° gilt. Dann beträgt $Q_{recording}$ = 0°. Für $\alpha_0$ = -21.8° und $\beta_0$ = 41.8° beträgt $Q_{recording}$ daher 10°. Allgemein gilt für das Interferenzfeld beim Schreiben ("recording") des Hologramms:

$$\alpha_0 = \theta_0 + \Omega_{recording}.$$

$\theta_0$ ist der Halbwinkel im Laborsystem außerhalb des Mediums und es gilt beim Schreiben des Hologramms:

$$\theta_0 = \frac{\alpha_0 - \beta_0}{2}.$$

In diesem Fall gilt also $\theta_0$ = -31.8°. An jedem angefahrenen Drehwinkel $\Omega$ wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel $\Omega$ als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels $\Omega$, des geschriebenen Hologramms gemessen und in einem Computer gespeichert. Zusätzlich wurde auch die in die nullte Ordnung transmittierte Intensität gegen den Drehwinkel $\Omega$ aufgezeichnet und in einem Computer gespeichert.

Die maximale Beugungseffizienz (DE = $\eta_{max}$) des Hologramms, also sein Spitzenwert, wurde bei $Q_{reconstruction}$ ermittelt. Eventuell musste dazu die Position des Detektors des abgebeugten Strahls verändert werden, um diesen maximalen Wert zu bestimmen.

Der Brechungsindexkontrast $\Delta n$ und die Dicke *d* der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Dabei ist zu beachten, dass wegen der durch die Photopolymerisation auftretenden Dickenschwindung der Streifenabstand $\Lambda'$ des Hologramms und die Orientierung der Streifen (slant) vom Streifenabstand A des Interferenzmusters und dessen Orientierung abweichen kann. Demnach wird auch der Winkel $\alpha_0'$ bzw. der entsprechende Winkel des Drehtisches $\Omega_{reconstruction}$, bei dem maximale Beugungseffizienz erreicht wird von $\alpha_0$ bzw. vom entsprechenden $\Omega_{recording}$ abweichen. Dadurch verändert sich die Bragg-Bedingung. Diese Veränderung wird im Auswerteverfahren berücksichtigt. Das Auswerteverfahren wird im Folgenden beschrieben:

Alle geometrischen Größen, die sich auf das geschriebene Hologramm beziehen und nicht auf das Interferenzmuster werden als gestrichene Größen dargestellt.

Für die Braggkurve $\eta(\Omega)$ eines Reflexionshologramms gilt nach Kogelnik:

$$\eta = \begin{cases} \dfrac{1}{1 - \dfrac{1-(\xi/\nu)^2}{\sin^2\left(\sqrt{\xi^2 - \nu^2}\right)}}, \text{ für } \nu^2 - \xi^2 < 0 \\ \dfrac{1}{1 + \dfrac{1-(\xi/\nu)^2}{\sinh^2\left(\sqrt{\nu^2 - \xi^2}\right)}}, \text{ für } \nu^2 - \xi^2 \geq 0 \end{cases}$$

mit:

$$\nu = \frac{\pi \cdot \Delta n \cdot d'}{\lambda \cdot \sqrt{|c_s \cdot c_r|}}$$

$$\xi = -\frac{d'}{2 \cdot c_s} \cdot DP$$

$$c_s = \cos(\vartheta') - \cos(\psi') \cdot \frac{\lambda}{n \cdot \Lambda'}$$

$$c_r = \cos(\vartheta')$$

$$DP = \frac{\pi}{\Lambda'} \cdot \left( 2 \cdot \cos(\psi' - \vartheta') - \frac{\lambda}{n \cdot \Lambda'} \right)$$

$$\psi' = \frac{\beta' + \alpha'}{2}$$

$$\Lambda' = \frac{\lambda}{2 \cdot n \cdot \cos(\psi' - \alpha')}$$

Beim Auslesen des Hologramms ("reconstruction") gilt wie analog oben dargestellt:

$$\vartheta'_0 = \theta_0 + \Omega$$

$$\sin(\vartheta'_0) = n \cdot \sin(\vartheta')$$

An der Bragg-Bedingung ist das "Dephasing" *DP* = 0. Und es folgt entsprechend:

$$\alpha'_0 = \theta_0 + \Omega_{reconstruction}$$

$$\sin(\alpha'_0) = n \cdot \sin(\alpha')$$

Der noch unbekannt Winkel β' kann aus dem Vergleich der Bragg-Bedingung des Interferenzfeldes beim Schreiben des Hologramms und der Bragg-Bedingung beim Auslesen des Hologramms ermittelt werden unter der Annahme, dass nur Dickenschwindung stattfindet. Dann folgt:

$$\sin(\beta') = \frac{1}{n} \cdot [\sin(\alpha_0) + \sin(\beta_0) - \sin(\theta_0 + \Omega_{reconstruction})]$$

ν ist die Gitterstärke, ξ ist der Detuning Parameter und ψ' die Orientierung (Slant) des Brechungsindexgitters das geschrieben wurde. α' und β' entsprechen den Winkeln $\alpha_0$ und $\beta_0$ des Interferenzfeldes beim Schreiben des Hologramms, aber im Medium gemessen und für das Gitter des Hologramms gültig (nach Dickenschwindung). n ist der mittlere Brechungsindex des Photopolymers und wurde zu 1.504 gesetzt. λ ist die Wellenlänge des Laserlichts im Vakuum.

Die maximale Beugungseffizienz (DE = $\eta_{max}$) ergibt sich dann für ξ = 0 zu:

$$DE = \tanh^2(\nu) = \tanh^2\left(\frac{\pi \cdot \Delta n \cdot d'}{\lambda \cdot \sqrt{\cos(\alpha') \cdot \cos(\alpha' - 2\psi)}}\right)$$

Figur 2 zeigt die gemessene transmittierte Leistung $P_T$ (rechte *y*-Achse) als durchgezogene Linie gegen das Winkeldetuning ΔΩ aufgetragen, die gemessene Beugungseffizienz η (linke *y*-Achse) als ausgefüllte Kreise gegen das Winkeldetuning ΔΩ aufgetragen (soweit die endliche Größe des Detektors es erlaubte) und die Anpassung der Kogelnik Theorie als gestrichelte Linie (linke *y*-Achse).

Die Messdaten der Beugungseffizienz, die theoretische Braggkurve und die transmittierte Intensität werden wie in Figur 2 gezeigt gegen den zentrierten Drehwinkel $\Delta\Omega = \Omega_{reconstruction} - \Omega = \alpha'_0 - \vartheta'_0$ auch Winkeldetuning genannt, aufgetragen.

Da DE bekannt ist wird die Form der theoretischen Braggkurve nach Kogelnik nur noch durch die Dicke *d'* der Photopolymerschicht bestimmt. Δn wird über DE für gegebene Dicke *d'* so nachkorrigiert, dass Messung und Theorie von DE immer übereinstimmen. *d'* wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für die theoretische Braggkurve und für die transmittierte Intensität übereinstimmen.

Da die Richtung in der ein Reflexionshologramm bei der Rekonstruktion mittels eines Ω-Scans mitrotiert, der Detektor für das abgebeugte Licht aber nur einen endlichen Winkelbereich erfassen kann, wird die Braggkurve von breiten Holgrammen (kleines *d'*) bei einem Ω-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke *d'* zusätzlich herangezogen.

Figur 2 zeigt die Darstellung der Braggkurve η nach der Coupled Wave Theorie (gestrichelte Linie), des gemessenen Beugungswirkungsgrades (ausgefüllte Kreise) und der transmittierten Leistung (schwarz durchgezogene Linie) gegen das Winkeldetuning ΔΩ.

Für eine Formulierung wurde diese Prozedur eventuell mehrfach für verschiedene Belichtungszeiten *t* an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis *E* ergibt sich wie folgt aus den Leistungen der zwei den Winkeln $\alpha_0$ und $\beta_0$ zugeordneten Teilstrahlen (Referenzstrahl mit $P_r$ = 0.50 mW und Signalstrahl mit $P_s$ = 0.63 mW), der Belichtungszeit t und dem Durchmesser der Irisblende (0.4 cm):

$$E\ (\text{mJ/cm}^2) = \frac{2 \cdot [P_r + P_s] \cdot t\ (\text{s})}{\pi \cdot 0.4^2\ \text{cm}^2}$$

Die Leistungen der Teilstrahlen wurden so angepasst, dass in dem Medium bei den verwendeten Winkeln $\alpha_0$ und $\beta_0$, die gleiche Leistungsdichte erreicht wird.

**Substanzen:**

Die verwendeten Alkohle und Cyanurchlorid sowie Lösungsmittel und Reagenzien wurden im Chemikalienhandel bezogen.

| | |
|---|---|
| CGI-909 | Tetrabutylammonium-tris(3-chlor-4-methylphenyl)(hexyl)borat, [1147315-11-4] ist ein von der CIBA Inc., Basel, Schweiz, hergestelltes Produkt. |
| Desmorapid Z | Dibutylzinn-dilaurat [77-58-7], Produkt der Bayer MaterialScience AG, Leverkusen, Deutschland. |
| Desmodur® N 3900 | Produkt der Bayer MaterialScience AG, Leverkusen, DE, Hexandiisocyanat-basiertes Polyisocyanat, Anteil an Iminooxadiazindion mindestens 30 %, NCO-Gehalt: 23.5 %. |
| Fomrez UL 28 | Urethanisierungskatalysator, Handelsprodukt der Momentive Performance Chemicals, Wilton, CT, USA. |

**Herstellung von 2,4-Dichlor-6-(1-naphthyloxy)-1,3,5-triazin [30886-30-7]**

In einem 2 L Rundkolben wurden 125.0 g Cyanurchlorid in 300 mL Aceton gelöst und eine Lösung von 96.8 g 1-Naphthol in 300 mL Aceton bei 0 °C langsam zugetropft. Anschliessend wurden 168 mL 4 N Natronlauge langsam zugetropft. Es wurde 1 h bei 0 °C nachgerührt, anschließend wurde auf Raumtemperatur erwärmt und 1 h nachgerührt. Die wässrige Phase wurde abgetrennt und zur organischen Phase wurden 200 mL 5%-ige NaOH und 200 mL Chloroform zugegeben, es wurde erneut die wässrige Phase abgetrennt und die organischen Phase wurde zweimal mit jeweils 80 mL 5%-iger NaOH und dreimal mit jeweils 180 mL Wasser gewaschen und über Natriumsulfat getrocknet. Es wurde filtriert und das Lösungsmittel wurde bei unter reduziertem Druck abdestilliert. Das Produkt wurde als farbloser Feststof erhalten (Herstellung beschrieben in WO 8704321).

**Beispiel 1: 1,3,5-Triazin-2,4,6-triyltris(oxyethan-2,1-diyl)trisacrylat [55008-80-5]**

In einem 2 L Rundkolben wurden 218.0 g Cyanurchlorid in 0.50 L Pyridin : Toluol (v:v = 1:1) bei 0 °C vorgelegt und 414 g 2-Hydroxyethylacrylat langsam zugetropft. Anschließend wurde auf Raumtemperatur errwärmt und solange nachgerührt, bis Gehalt an 2-Hydroxyethylacrylat unter 0.1 % gesunken war. Das Reaktionsgemisch wurde auf 1 L Eiswasser gegeben und mit 2 N Salzsäure angesäuert. Die wässrige Phase wurde dreimal mit jeweils 0.5 L Dichlormethan extrahiert, die vereinigten organischen Phasen wurden mit 0.5 L 10%-iger wässriger Natriumhydrogencarbonat-Lösung gewaschen und über Natriumsulfat getrocknet. Das Lösungsmittel wurde abdestilliert und das Produkt wurde als farbloses Öl erhalten (Herstellung beschrieben in JP 56152467 A und JP 49125380).

**Beispiel 2: 1,3,5-Triazin-2,4,6-triyltris(oxybutan-4,1-diyl)trisacrylat**

In einem 0.5 L Rundkolben wurden 55.6 g Cyanurchlorid und 127.8 g 4-Hydroxybutylacrylat bei 0 °C in 87 mL Wasser suspendiert vorgelegt und 210 mL 4 N Natronlauge langsam zugetropft. Es wurde 1 h bei 0 °C nachgerührt und anschließend wurde auf Raumtemperatur erwärmt. Das Reaktionsgemisch wurde auf 0.3 L Wasser gegeben und dreimal mit jeweils 0.3 L Dichlormethan extrahiert, die vereinigten organischen Phasen wurden mit 0.1 L 1 N Salzsäure und zweimal mit 0.2 L Wasser gewaschen und über Natriumsulfat getrocknet. Es wurden 0.05 g 2,6-Di-tert.-butyl-4-methylphenol zugegeben, das Lösungsmittel wurde abdestilliert und das Produkt wurde als farbloses Öl erhalten.

**Beispiel 3: 1,3,5-Triazin-2,4,6-triyltris(oxyethan-2,1-diyl)tris(2-methylacrylat)**

In einem 0.5 L Rundkolben wurden 34.0 g Cyanurchlorid in 270 mL Aceton gelöst und 86.2 g 2-Hydroxyethylmethacrylat bei 0 °C langsam zugetropft. Anschliessend wurden 138 mL 4 N Natronlauge langsam zugetropft. Es wurde 1 h bei 0 °C nachgerührt und anschließend wurde auf Raumtemperatur erwärmt. Die wässrige Phase wurde abgetrennt und zur organisehen Phase wurden 200 mL 5%-ige NaOH und 200 mL Methylenchlorid zugegeben, es wurde erneut die wässrige Phase abgetrennt und die organischen Phase wurde zweimal mit jeweils 80 mL 5%-ige NaOH und dreimal mit jeweils 180 mL Wasser gewaschen und über Natriumsulfat getrocknet. Es wurden 0.05 g Hydrochinon (gelöst in Methylenchlorid) zugegeben, filtriert und das Lösungsmittel wurde bei maximal 45 °C Sumpftemperatur unter reduziertem Druck abdestilliert. Das Produkt wurde als farbloses Öl erhalten.

**<u>Beispiel 4:</u> Gemisch aus 1,3,5-Triazin-2,4,6-triyltris(oxypropan-2,1-diyl)trisacrylat und 1,3,5-Triazin-2,4,6-triyltris(oxypropan-1,2-diyl)trisacrylat**

In einem 0.5 L Rundkolben wurden 34.0 g Cyanurchlorid in 270 mL Aceton gelöst und 86.2 g Hydroxy-propylacrylat bei 0 °C langsam zugetropft. Anschliessend wurden 138 mL 4 N Natronlauge langsam zugetropft. Es wurde 1 h bei 0 °C nachgerührt und anschließend wurde auf Raumtemperatur erwärmt. Die wässrige Phase wurde abgetrennt und zur organischen Phase wurden 200 mL 5%-ige NaOH und 200 mL Methylenchlorid zugegeben, es wurde erneut die wässrige Phase abgetrennt und die organischen Phase wurde zweimal mit jeweils 80 mL 5%-ige NaOH und dreimal mit jeweils 180 mL Wasser gewaschen und über Natriumsulfat getrocknet. Es wurden 0.05 g Hydrochinon (gelöst in Methylenchlorid) zugegeben, filtriert und das Lösungsmittel wurde bei maximal 45 °C Sumpftemperatur unter reduziertem Druck abdestilliert. Das Produkt wurde als farbloses Öl erhalten.

**<u>Beispiel 5:</u> 2-({4-[4-(Acryloyloxy)butoxyl-6-[2-(acryloyloxy)propoxy]-1,3,5-triazin-2-yl}oxy)ethyl-2-methylacrylat (Idealstruktur 1:1:1 Produkt)**

In einem 0.5 L Rundkolben wurden 34.0 g Cyanurchlorid in 270 mL Aceton gelöst und ein Gemisch aus 27.8 mL 2-Hydroxyethylmethacrylat, 27.8 mL Hydroxy-propylacrylat und 30.9 mL 4-Hydroxybutylacrylat bei 0 °C langsam zugetropft. Anschliessend wurden 138 mL 4 N Natronlauge langsam zugetropft. Es wurde 1 h bei 0 °C nachgerührt und anschließend wurde auf Raumtemperatur erwärmt. Die wässrige Phase wurde abgetrennt und zur organischen Phase wurden 200 mL 5%-ige NaOH und 200 mL Methylenchlorid zugegeben, es wurde erneut die wässrige Phase abgetrennt und die organischen Phase wurde zweimal mit jeweils 80 mL 5%-ige NaOH und dreimal mit jeweils 180 mL Wasser gewaschen und über Natriumsulfat getrocknet. Es wurden 0.05 g Hydrochinon (gelöst in Methylenchlorid) zugegeben, filtriert und das Lösungsmittel wurde bei maximal 45 °C Sumpftemperatur unter reduziertem Druck abdestilliert. Das Produkt wurde als farbloses Öl erhalten.

**<u>Beispiel 6:</u> [6-(1-Naphthyloxy)-1,3,5-triazin-2,4-diyl]bis(oxyethan-2,1-diyl)bisacrylat**

In einem 0.5 L Rundkolben wurden 12.9 g 2,4-Dichlor-6-(1-naphthyloxy)-1,3,5-triazin [30886-30-7] in 60 mL Aceton gelöst und 10.3 mL 2-Hydroxyethylacrylat bei 0 °C langsam zugetropft. Anschliessend wurden 22.2 mL 4 N Natronlauge langsam zugetropft. Es wurde 1 h bei 0 °C nachgerührt und anschließend wurde auf Raumtemperatur erwärmt. Die wässrige Phase wurde abgetrennt und zur organischen Phase wurden 50 mL 5%-ige NaOH und 50 mL Chloroform zugegeben, es wurde erneut die wässrige Phase abgetrennt und die organischen Phase wurde zweimal mit jeweils 20 mL 5%-iger NaOH und dreimal mit jeweils 50 mL Wasser gewaschen und über Natriumsulfat getrocknet. Es wurden 0.005 g Hydrochinon (gelöst in Aceton) zugegeben, filtriert und das Lösungsmittel wurde bei maximal 45 °C Sumpftemperatur unter reduziertem Druck abdestilliert. Das Produkt wurde als farbloses Öl erhalten.

Die Beispiele 7-11 wurden analog zu Beispiel 6 aus den in Tabelle 1 angegebenen Rohstoffen hergestellt.

**<u>Vergleichsbeispiel 1:</u> 2-[(Phenylcarbamoyl)oxy]ethylprop-2-enoat []**

In einem 500 mL Rundkolben wurden 0.25 g 2,6-Di-tert.-butyl-4-methylphenol, 0.12 g Desmorapid Z und 126.4 g Phenylisocyanat vorgelegt und auf 60 °C erwärmt. Anschließend wurden 123.3 g 2-Hydroxyethylacrylat zugetropft und die Mischung weiter auf 60 °C gehalten, bis der Isocyanatgehalt unter 0.1 % gesunken war. Danach wurde abgekühlt. Das Produkt wurde als kristalliner Feststoff erhalten (Herstellung beschrieben in DE 2329142). Das Produkt hat einen Schmelzpunkt von 66-68° C (Bowman, Macromolecules, 2004, 37 (11), 4062-4069).

Tabelle 1: Übersicht über Triazin-basierte Schreibmonomere und das Vergleichsbeispiel

| Beispiel | Name | $R^1$ | $R^2$ | $R^3$ | n (Methode) | μ (25°C) [mPas] | Beschreibung |
|---|---|---|---|---|---|---|---|
| 1 | 1,3,5-Triazin-2,4,6-triyltris-(oxyethan-2,1-diyl)trisacrylat | 2-Hydroxy-ethylacrylat | 2-Hydroxy-ethylacrylat | 2-Hydroxy-ethylacrylat | 1.598 (A) | - | Farbloses Öl |
| 2 | 1,3,5-Triazin-2,4,6-triyltris(oxybutan-4,1-diyl)trisacrylat | 4-Hydroxy-butylacrylat | 4-Hydroxy-butylacrylat | 4-Hydroxy-butylacrylat | - | - | Farbloses Öl |
| 3 | 1,3,5-Triazin-2,4,6-triyltris(oxyethan-2,1-diyl)tris(2-methylacrylat) | 2-Hydroxy-ethylmethacrylat | 2-Hydroxy-ethylmethacrylat | 2-Hydroxy-ethylmethacrylat | 1.500 (B) | - | Farbloses Öl |
| 4 | Gemisch aus 1,3,5-Triazin-2,4,6-triyltris(oxypropan-2,1-diyl)trisacrylat und 1,3,5-Triazin-2,4,6-triyltris(oxypropan-1,2-diyl)trisacrylat | Hydroxy-propylacrylat | Hydroxy-propylacrylat | Hydroxy-propylacrylat | 1.500 (B) | 13600 | Farbloses Öl |
| 5 | 2-({4-[4-(Acryloyloxy)butoxy]-6-[2-(acryloyloxy)propoxy]-1,3,5-triazin-2-yl} oxy)ethyl-2-methylacrylat (Idealstruktur 1:1:1 Produkt) | 2-Hydroxy-ethylmethacrylat | Hydroxy-propylacrylat | 4-Hydroxy-butylacrylat | 1.503 (B) | 895 | Farbloses Öl |

(fortgesetzt)

| Beispiel | Name | $R^1$ | $R^2$ | $R^3$ | n (Methode) | μ (25°C) [mPas] | Beschreibung |
|---|---|---|---|---|---|---|---|
| 6 | [6-(1-Naphthyloxy)-1,3, 5-triazin-2,4-diyl]bis(oxyethan-2,1-diyl)bisacrylat | 1-Naphthol | 2-Hydroxy-ethylacrylat | 2-Hydroxy-ethylacrylat | 1.530 (B) | - | Farbloses Öl |
| 7 | [6-(1-Naphthyloxy)-1,3, 5-triazin-2,4-diyl]bis(oxyethan-2,1-diyl)bis(2-methylacrylat) | 1-Naphthol | 2-Hydroxy-ethylmethacrylat | 2-Hydroxy-ethylmethacrylat | 1.580 (B) | 24570 | Farbloses Öl |
| 8 | 2-({4-[2-(Acryloyloxy)ethoxy]-6-(1-naphthyloxy)-1,3,5-triazin-2-yl}oxy)ethyl-2-methylacrylat | 1-Naphthol | 2-Hydroxy-ethylacrylat | 2-Hydroxy-ethylmethacrylat | 1.583 (B) | - | Farbloses Öl |
| 9 | 2-({4-[4-(Acryloyloxy)butoxy]-6-(1-naphthyloxy)-1,3,5-triazin-2-yl}oxy)ethyl-2-methylacrylat | 1-Naphthol | 4-Hydroxy-butylacrylat | 2-Hydroxy-ethylmethacrylat | 1.569 (B) | - | Farbloses Öl |
| 10 | 2-({4-[4-(Acryloyloxy)butoxy]-6-(1-naphthyloxy)-1,3,5-triazin-2-yl}oxy)ethylacrylat | 1-Naphthol | 2-Hydroxy-ethylacrylat | 4-Hydroxy-butylacrylat | - | - | Farbloses Öl |

(fortgesetzt)

| Beispiel | Name | $R^1$ | $R^2$ | $R^3$ | n (Methode) | μ (25°C) [mPas] | Beschreibung |
|---|---|---|---|---|---|---|---|
| 11 | [6-(1-Naphthyl-oxy)-1,3, 5-tri-azin-2,4-di-yl]bis(oxybutan-4,1-diyl)bisacrylat | 1-Naphthol | 4-Hydroxy-butylacrylat | 4-Hydroxy-butylacrylat | 1.560 (B) | - | Farbloses Öl |
| Vergleichs beispiel 1 | 2-[(Phenylcar-bamoyl)oxy]-eth ylprop-2-enoat | - | - | - | 1.591 (A) | - | Farbloser Feststoff |

Zur Prüfung der optischen Eigenschaften wurden wie im Folgenden beschrieben Medien hergestellt und optisch vermessen:

**Herstellung der Polyol-Komponente:**

In einem 1 L Kolben wurden 0.18 g Zinnoctoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

**Herstellung des Urethanacrylates 1: 2-({[3-(Methylsulfanyl)phenyl]carbamoyl}oxy)-ethylprop-2-enoat**

In einem 100 mL Rundkolben wurden 0.02 g 2,6-Di-tert.-butyl-4-methylphenol, 0.01 g Desmorapid Z, 11.7 g 3-(Methylthio)phenylisocyanat vorgelegt und vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0.1 % gesunken war. Danach wurde abgekühlt. Das Produkt wurde als farblose Flüssigkeit erhalten.

**Herstellung des fluorierten Urethans 1: 2,2,3,3,4,4,5,5,6,6,7,7,8,8,9,9-Hexadecafluornonyl-butylcarbamat**

In einem 1 L Rundkolben wurden 0.50 g Desmorapid Z und 186 g n-Butylisocyanat vorgelegt und auf 60 °C erwärmt. Anschließend wurden 813 g 2,2,3,3,4,4,5,5,6,6,7,7,8,8,9,9-Hexadecafluornonanol zugetropft und die Mischung weiter auf 60 °C gehalten, bis der Isocyanatgehalt unter 0.1 % gesunken war. Danach wurde abgekühlt. Das Produkt wurde als farbloses Öl erhalten.

**<u>Herstellung der Medien</u>**

**Medium 1 (Formulierung 1):**

5.927 g der wie oben beschrieben hergestellten Polyol-Komponente wurden mit 2.50 g Acrylat aus Beispiel 1, 0.10 g CGI 909 und 0.010 g Neu Methylenblau bei 60 °C und 0.35 g N-Ethylpyrilidon gemischt so dass eine klare Lösung erhalten wurde. Anschließend wurde auf 30 °C abgekühlt, 1.098 g Desmodur® N 3900 zugegeben und erneut gemischt. Schließlich wurden 0.006 g Fomrez UL 28 zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde 12 h bei Raumtemperatur liegen gelassen und gehärtet.

**Medien 2-5:**

Die Medien 2-5 wurden in analoger Art und Weise aus den in Tabelle 2 aufgeführten Beispielen hergestellt.

**Medium 6 (Formulierung 2):**

3.40 g der wie oben beschrieben hergestellten Polyol-Komponente wurden mit 2.00 g 1,3,5-Triazin-2,4,6-triyltris(oxyethan-2,1-diyl)trisacrylat (Beispiel 1), 2.00 g 2-({[3-(Methylsulfanyl)phenyl]carbamoyl}oxy)propylprop-2-enoat (Urethanacrylat 1), 1.50 g 2,2,3,3,4,4,5,5,6,6,7,7,8,8,9,9-Hexadecafluornonyl-butylcarbamat (fluoriertes Urethan 1), 0.10 g CGI 909, 0.01 g Neu Methylenblau und 0.35 g N-Ethylpyrrolidon bei 60 °C gemischt, so dass eine klare Lösung erhalten wurde. Anschließend wurde auf 30 °C abgekühlt, 0.63 g Desmodur N3900 zugegeben und erneut gemischt. Schließlich wurden 0.006 g Fomrez UL 28 zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde 12 Stunden bei Raumtemperatur liegen gelassen und gehärtet.

**Medien 7-11:**

Die Medien 7-11 wurden in analoger Art und Weise aus den in Tabelle 3 aufgeführten Beispielen hergestellt.

**Vergleichsmedium 1:**

5.927 g der wie oben beschrieben hergestellten Polyol-Komponente wurden mit 2.50 g 2-[(Phenylcarbamoyl)oxy]ethylprop-2-enoat (Vergleichsbeispiel 1), 0.10 g CGI 909 und 0.010 g Neu Methylenblau bei 60 °C und 0.35 g N-Ethylpyrilidon gemischt, so dass eine klare Lösung erhalten wurde. Anschließend wurde auf 30 °C abgekühlt, 1.098 g Desmodur® N 3900 zugegeben und erneut gemischt. Schließlich wurden 0.006 g Fomrez UL 28 zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Probenkörper wurde 12 h bei Raumtemperatur liegen gelassen und gehärtet.

**Holographische Prüfung:**

Die wie beschrieben hergestellten Medien wurden anschließend mittels einer Messanordnung gemäß Figur 1 in der oben beschriebenen Weise auf ihre holographischen Eigenschaften geprüft. Dabei ergaben sich folgende Werte für $\Delta n_{sat}$ bei der Dosis E [mJ/cm$^2$]:

Tabelle 2: Holographische Bewertung ausgewählter Beispiele in der Formulierung 1

| Medium | Beispiel | $\Delta n_{sat}$ | Dosis E [mJ/cm$^2$] |
|---|---|---|---|
| 1 | 1 | 0.0099 | 18 |
| 2 | 2 | 0.0081 | 18 |
| 3 | 4 | 0.0058 | 18 |
| 4 | 5 | 0.0056 | 18 |
| 5 | 6 | 0.0066 | 9 |
| Vergleichsmedium 1 | Vergleichsbeispiel 1 | 0.0044 | 73 |

Tabelle 3: Holographische Bewertung ausgewählter Beispiele in der Formulierung 2

| Medium | Beispiel | $\Delta n_{sat}$ | Dosis E [mJ/cm$^2$] |
|---|---|---|---|
| 6 | 1 | 0.0253 | 18 |
| 7 | 2 | 0.0219 | 18 |
| 8 | 3 | 0.0175 | 18 |
| 9 | 4 | 0.0258 | 9 |
| 10 | 5 | 0.0199 | 18 |
| 11 | 6 | 0.0192 | 4 |

Die gefundenen Werte für $\Delta n_{sat}$ zeigen, dass das im Vergleichsmedium verwendete Urethanacrylat für die Verwendung in holographischen Medien weniger geeignet ist, wohingegen die Acrylate in den Medien 1 bis 5 sowie 6 bis 11 für die Herstellung holographischer Medien aufgrund des höheren Wertes für $\Delta n_{sat}$ sehr gut geeignet sind. Zudem zeichnen sich die beschriebenen Acrylate relativ durch eine niedrigere Viskosität aus, was die Transportierbarkeit und Verarbeitbarkeit in einer resultierenden Photopolymer-Formulierung deutlich verbessert, wogegen das Vergleichsbeispiel erst deutlich über Raumtemperatur schmilzt und daher schwerer zu verarbeiten ist.

## Patentansprüche

1. Verwendung einer Photopolymer-Formulierung umfassend Polyurethan Matrixpolymere, Schreibmonomere und Photoinitiatoren zur Herstellung holographischer Medien, **dadurch gekennzeichnet, dass** die Schreibmonomere Verbindungen der Formel (I) enthalten

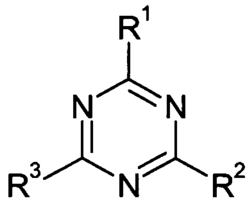

(I)

in der

$R^1$, $R^2$, $R^3$ jeweils unabhängig voneinander OH, Halogen oder ein organischer Rest sind, wobei wenigstens einer der Reste ein eine strahlungshärtende Gruppe aufweisender organischer Rest ist.

2. Verwendung nach Anspruch 1, **dadurch gekennzeichnet, dass** der oder die organischen Reste über ein Sauerstoff- oder ein Stickstoffatom am Triazinring gebunden sind.

3. Verwendung nach einem der Ansprüche 1 oder 2, **dadurch gekennzeichnet, dass** die strahlungshärtende Gruppe eine Acrylat- oder eine Methacrylat-Gruppe ist.

4. Verwendung nach einem der Ansprüche 1 bis 3, **dadurch gekennzeichnet, dass** $R^1$, $R^2$, $R^3$ unabhängig voneinander Halogen, substituierte oder unsubstituierte Phenol-, Naphtol-, Anilin-, Naphtalin-, 2-Hydroxyethyl(meth)acrylat-, Hydroxypropyl(meth)acrylat- und / oder 4-Hydroxybutyl(meth)acrylat-Reste sind, wobei wenigstens einer der Reste $R^1$, $R^2$, $R^3$ ein 2-Hydroxyethyl(meth)acrylat-, ein Hydroxypropyl(meth)acrylat- oder ein 4-Hydroxybutyl(meth)acrylat-Rest ist.

5. Verwendung nach Anspruch 4, **dadurch gekennzeichnet, dass** wenigstens zwei der Reste $R^1$, $R^2$, $R^3$ jeweils unabhängig voneinander ein 2-Hydroxyethyl(meth)acrylat-, ein Hydroxypropyl(meth)acrylat- und / oder ein 4-Hydroxybutyl(meth)acrylat-Rest sind.

6. Verwendung nach einem der Ansprüche 1 bis 5, **dadurch gekennzeichnet, dass** die Photoinitiatoren einen anionischen, kationischen oder neutralen Farbstoff und einen Coinitiator umfassen.

7. Verwendung nach einem der Ansprüche 1 bis 6, **dadurch gekennzeichnet, dass** sie zusätzlich Urethane als Weichmacher enthält, wobei die Urethane insbesondere mit wenigstens einem Fluoratom substituiert sein können.

8. Verwendung nach Anspruch 7, **dadurch gekennzeichnet, dass** die Urethane die allgemeine Formel (II)

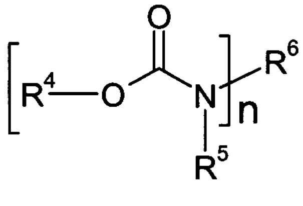

(II)

haben, in der n ≥1 und n ≤8 ist und $R^4$, $R^5$, $R^6$ unabhängig voneinander Wasserstoff, lineare, verzweigte, cyclische oder heterocyclische unsubstituierte oder gegebenenfalls auch mit Heteroatomen substituierte organische Reste sind, wobei bevorzugt mindestens einer der Reste $R^4$, $R^5$, $R^6$ mit wenigstens einem Fluoratom substituiert ist und besonders bevorzugt $R^4$ ein organischer Rest mit mindestens einem Fluoratom ist.

9. Verwendung nach einem der Ansprüche 1 bis 8, **dadurch gekennzeichnet, dass** die Schreibmonomere zusätzlich ein weiters mono- oder multifunktionales Schreibmonomer umfassen, wobei es sich insbesondere um ein mono- oder multifunktionelles Acrylat handeln kann.

10. Verwendung nach Anspruch 9, **dadurch gekennzeichnet, dass** das Acrylat die allgemeine Formel (III)

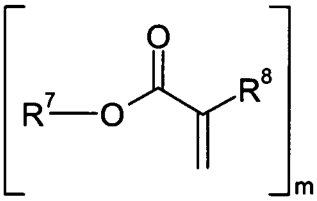

(III)

hat, in der m ≥1 und m ≤4 ist und $R^7$, $R^8$ unabhängig voneinander Wasserstoff, lineare, verzweigte, cyclische oder heterocyclische unsubstituierte oder gegebenenfalls auch mit Heteroatomen substituierte organische Reste sind.

**11.** Verwendung nach einem der Ansprüche 1 bis 10 zur Herstellung von In-Line Hologrammen, Off-Axis Hologrammen, Full-Aperture Transfer Hologrammen, Weißlicht-Transmissionshologrammen, Denisyukhologrammen, Off-Axis Reflektionshologrammen, Edge-Lit Hologrammen sowie holographischen Stereogrammen.

**Claims**

**1.** Use of a photopolymer formulation comprising polyurethane matrix polymers, writing monomers and photoinitiators for production of holographic media, **characterized in that** the writing monomers comprise compounds of the formula (I)

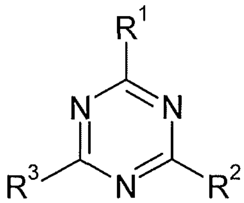

(I)

in which

$R^1$, $R^2$, $R^3$ are each independently OH, halogen or an organic radical, where at least one of the radicals is an organic radical having a radiation-curing group.

**2.** Use according to Claim 1, **characterized in that** the organic radical(s) is/are bonded to the triazine ring via an oxygen or nitrogen atom.

**3.** Use according to either of Claims 1 and 2, **characterized in that** the radiation-curing group is an acrylate or methacrylate group.

**4.** Use according to any of Claims 1 to 3, **characterized in that** $R^1$, $R^2$, $R^3$ are each independently halogen and/or substituted or unsubstituted phenol, naphthol, aniline, naphthalene, 2-hydroxyethyl (meth)acrylate, hydroxypropyl (meth)acrylate and/or 4-hydroxybutyl (meth)acrylate radicals, where at least one of the $R^1$, $R^2$, $R^3$ radicals is a 2-hydroxyethyl (meth)acrylate, hydroxypropyl (meth)acrylate or 4-hydroxybutyl (meth)acrylate radical.

**5.** Use according to Claim 4, **characterized in that** at least two of the $R^1$, $R^2$, $R^3$ radicals are each independently a 2-hydroxyethyl (meth)acrylate, hydroxypropyl (meth)acrylate and/or 4-hydroxybutyl (meth)acrylate radical.

**6.** Use according to any of Claims 1 to 5, **characterized in that** the photoinitiators comprise an anionic, cationic or uncharged dye and a coinitiator.

**7.** Use according to any of Claims 1 to 6, **characterized in that** it additionally comprises urethanes as plasticizers, where the urethanes may especially be substituted by at least one fluorine atom.

**8.** Use according to Claim 7, **characterized in that** the urethanes have the general formula (II)

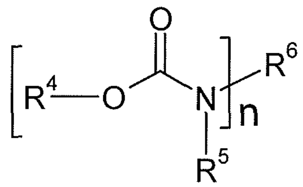

(II)

in which n≥1 and n≤8 and $R^4$, $R^5$, $R^6$ are each independently hydrogen, linear, branched, cyclic or heterocyclic organic radicals which are unsubstituted or else optionally substituted by heteroatoms, where preferably at least one of the $R^4$, $R^5$, $R^6$ radicals is substituted by at least one fluorine atom, and $R^4$ is more preferably an organic radical with at least one fluorine atom.

**9.** Use according to any of Claims 1 to 8, **characterized in that** the writing monomers additionally comprise a further mono- or polyfunctional writing monomer, which may especially be a mono- or polyfunctional acrylate.

**10.** Use according to Claim 9, **characterized in that** the acrylate has the general formula (III)

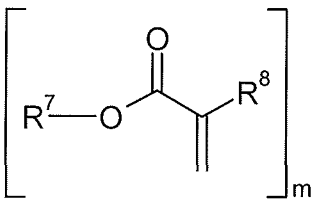

(III)

in which m≥1 and m≤4 and $R^7$, $R^8$ are each independently hydrogen, linear, branched, cyclic or heterocyclic organic radicals which are unsubstituted or else optionally substituted by heteroatoms.

**11.** Use according to any of Claims 1 to 10 for production of inline holograms, off-axis holograms, full-aperture transfer holograms, white light transmission holograms, Denisyuk holograms, off-axis reflection holograms, edge-lit holograms and holographic stereograms.

## Revendications

**1.** Utilisation d'une formulation de photopolymère comprenant des polymères de matrice de polyuréthane, des monomères d'enregistrement et des photo-initiateurs pour la production de moyens holographiques, **caractérisée en ce que** les monomères d'enregistrement contiennent des composés de formule (I)

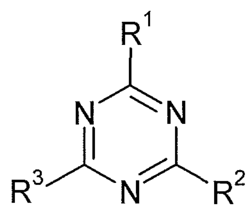

(I)

dans laquelle

$R^1$, $R^2$, $R^3$ représentent, à chaque fois indépendamment les uns des autres, OH, halogène ou un radical organique, au moins un des radicaux étant un radical organique présentant un groupe durcissant sous l'effet

d'un rayonnement.

**2.** Utilisation selon la revendication 1, **caractérisée en ce que** le ou les radicaux organiques sont liés via un atome d'oxygène ou un atome d'azote au cycle triazinique.

**3.** Utilisation selon l'une quelconque des revendications 1 à 2, **caractérisée en ce que** le groupe durcissant sous l'effet d'un rayonnement est un groupe acrylate ou un groupe méthacrylate.

**4.** Utilisation selon l'une quelconque des revendications 1 à 3, **caractérisée en ce que** $R^1$, $R^2$, $R^3$ représentent, indépendamment les uns des autres, halogène, des radicaux phénol, naphtol, aniline, naphtalène, (méth)acrylate de 2-hydroxyéthyle, (méth)acrylate d'hydroxypropyle et/ou (méth)acrylate de 4-hydroxybutyle substitués ou non substitués, au moins un des radicaux $R^1$, $R^2$, $R^3$ étant un radical (méth)acrylate de 2-hydroxyéthyle, (méth)acrylate d'hydroxypropyle ou (méth)acrylate de 4-hydroxybutyle.

**5.** Utilisation selon la revendication 4, **caractérisée en ce que** au moins deux des radicaux $R^1$, $R^2$, $R^3$ représentent, à chaque fois indépendamment l'un de l'autre, un radical (méth)acrylate de 2-hydroxyéthyle, (méth)acrylate d'hydroxypropyle et/ou (méth)acrylate de 4-hydroxybutyle.

**6.** Utilisation selon l'une quelconque des revendications 1 à 5, **caractérisée en ce que** les photo-initiateurs comprennent un colorant anionique, cationique ou neutre et un co-initiateur.

**7.** Utilisation selon l'une quelconque des revendications 1 à 6, **caractérisée en ce que** qu'elle contient en outre, comme plastifiant, des uréthanes, les uréthanes pouvant en particulier être substitués par au moins un atome de fluor.

**8.** Utilisation selon la revendication 7, **caractérisée en ce que** les uréthanes présentent la formule générale (II)

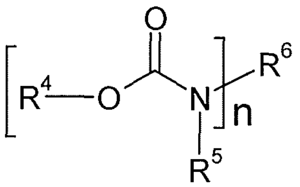

(II)

dans laquelle $n \geq 1$ et $n \leq 8$ et $R^4$, $R^5$, $R^6$ représentent, indépendamment les uns des autres, hydrogène, des radicaux organiques linéaires, ramifiés, cycliques ou hétérocycliques, non substitués ou le cas échéant également substitués par des hétéroatomes, de préférence au moins un des radicaux $R^4$, $R^5$, $R^6$ étant substitué par au moins un atome de fluor et $R^4$ représentant de manière particulièrement préférée un radical organique comprenant au moins un atome de fluor.

**9.** Utilisation selon l'une quelconque des revendications 1 à 8, **caractérisée en ce que** les monomères d'enregistrement comprennent en outre un autre monomère d'enregistrement monofonctionnel ou multifonctionnel, où il peut en particulier s'agir d'un acrylate monofonctionnel ou multifonctionnel.

**10.** Utilisation selon la revendication 9, **caractérisée en ce que** l'acrylate présente la formule générale (III)

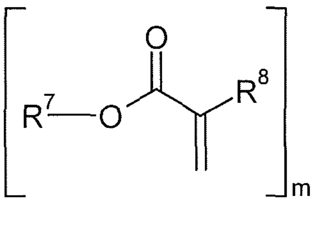

(III)

dans laquelle m ≥ 1 et m ≤ 4 et $R^7$, $R^8$ représentent, indépendamment l'un de l'autre, hydrogène, des radicaux organiques linéaires, ramifiés, cycliques ou hétérocycliques, non substitués ou le cas échéant également substitués par des hétéroatomes.

**11.** Utilisation selon la revendication 1 à 10 pour la production d'hologrammes en ligne, d'hologrammes hors axe, d'hologrammes de transfert à pleine ouverture, d'hologrammes de transmission en lumière blanche, d'hologrammes de Denisyuk, d'hologrammes de réflexion hors axe, d'hologrammes à éclairage périphérique ainsi que de stéréogrammes holographiques.

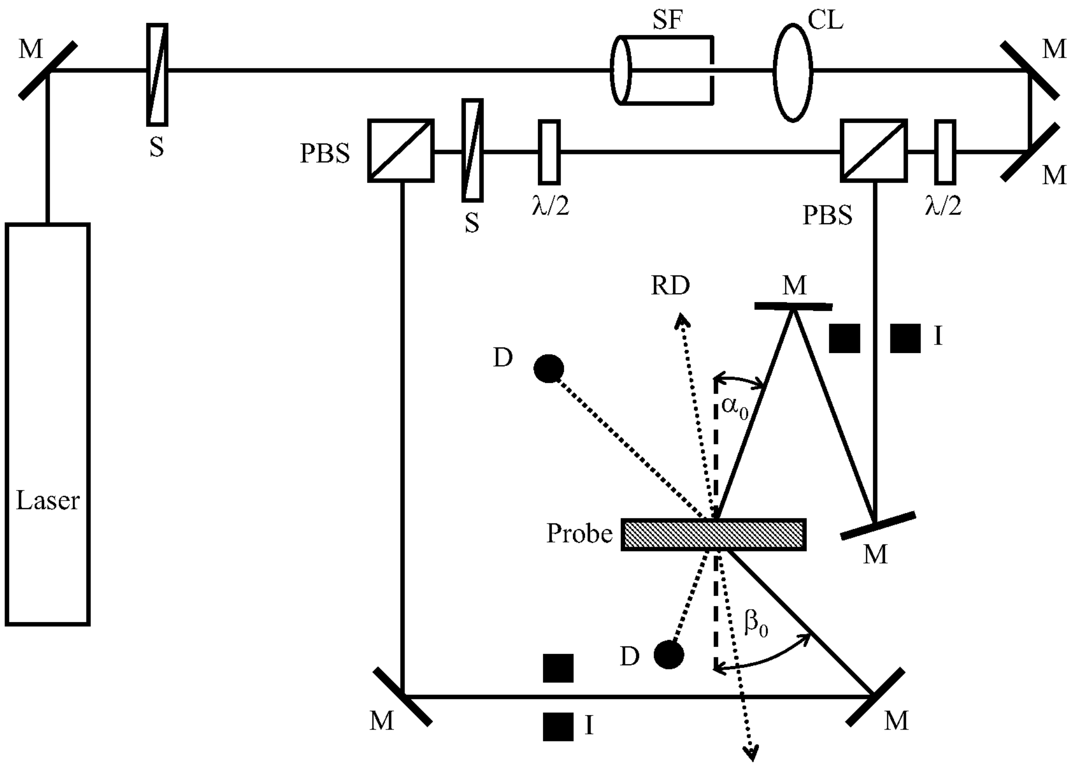
M
S
SF
CL
M
PBS
S
λ/2
PBS
λ/2
M
Laser
RD
M
D
I
$\alpha_0$
Probe
M
$\beta_0$
D
M
I
M

Fig. 1

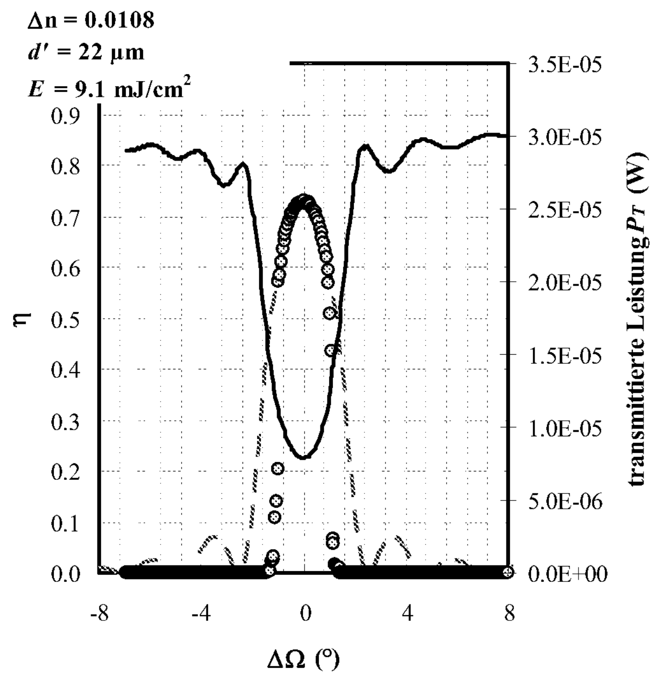
Δn = 0.0108
d' = 22 µm
E = 9.1 mJ/cm²
η
ΔΩ (°)
transmittierte Leistung $P_T$ (W)
0.0
0.1
0.2
0.3
0.4
0.5
0.6
0.7
0.8
0.9
-8
-4
0
4
8
0.0E+00
5.0E-06
1.0E-05
1.5E-05
2.0E-05
2.5E-05
3.0E-05
3.5E-05

Fig. 2

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008125229 A1
- JP 2004300046 A
- EP 1229389 A1
- EP 0859283 A1
- SU 2006990
- JP 58004027 B
- EP 0223587 A
- WO 8704321 A
- JP 56152467 A
- JP 49125380 B
- DE 2329142


### In der Beschreibung aufgeführte Nicht-Patentliteratur


- **P. HARIHARAN.** Optical Holography. Cambridge University Press, 1996
- **CUNNINGHAM et al.** *RadTech'98 North America UV/EB Conference Proceedings,* 19. April 1998
- **KUTAL et al.** *Macromolecules,* 1991, vol. 24, 6872
- **YAMAGUCHI et al.** *Macromolecules,* 2000, vol. 33, 1152
- **NECKERS et al.** *Macromolecules,* 2000, vol. 33, 7761
- **LI et al.** *Polymeric Materials Science and Engineering,* 2001, vol. 84, 139
- **DEKTAR et al.** *J. Org. Chem.,* 1990, vol. 55, 639
- *J. Org. Chem.,* 1991, vol. 56, 1838
- **CRIVELLO et al.** *Macromolecules,* 2000, vol. 33, 825
- **GU et al.** *Am. Chem. Soc. Polymer Preprints,* 2000, vol. 41 (2), 1266
- **HUA et al.** *Macromolecules,* 2001, vol. 34, 2488-2494
- Chemistry & Technology of UV & EB Formulations For Coatings. **BEISPIEL.** Inks & Paints. SITA Technology, 1991, vol. 3, 61-328
- **NG, WILLIE W. ; HONG, CHI-SHAIN ; YARIV, AMNON.** Holographic interference lithography for integrated optics. *IEEE Transactions on Electron Devices,* 1978, vol. ED-25 (10), ISSN 0018-9383, 1193-1200
- **H. KOGELNIK.** *The Bell System Technical Journal,* November 1969, vol. 48 (9), 2909, , 2947
- **BOWMAN.** *Macromolecules,* 2004, vol. 37 (11), 4062-4069